(19) **Europäisches Patentamt**

**European Patent Office**

**Office européen des brevets**

(11) **EP 1 356 593 B1**

(12) **EUROPÄISCHE PATENTSCHRIFT**

(45) Veröffentlichungstag und Bekanntmachung des Hinweises auf die Patenterteilung:
**24.08.2005 Patentblatt 2005/34**

(21) Anmeldenummer: 02706728.9

(22) Anmeldetag: **23.01.2002**

(51) Int Cl.⁷: $H03M\ 3/02$

(86) Internationale Anmeldenummer:
**PCT/EP2002/000656**

(87) Internationale Veröffentlichungsnummer:
**WO 2002/061947 (08.08.2002 Gazette 2002/32)**

(54) **ANORDNUNG ZUM LAUFZEITAUSGLEICH EINER DURCH EINE NACHBILDUNG EINES HOCHFREQUENZSIGNALS AUFTRETENDEN LAUFZEITDIFFERENZ**

ARRANGEMENT FOR COMPENSATING A PROPAGATION DELAY DIFFERENCE ARISING THROUGH EMULATION OF A HIGH FREQUENCY SIGNAL

DISPOSITIF DE COMPENSATION DE LA DIFFERENCE DE TEMPS DE PROPAGATION PROVOQUEE PAR LA SIMULATION D'UN SIGNAL HAUTE FREQUENCE

(84) Benannte Vertragsstaaten:
**DE FR GB IT**

(30) Priorität: **29.01.2001 DE 10103812**
**29.01.2001 EP 01101968**

(43) Veröffentlichungstag der Anmeldung:
**29.10.2003 Patentblatt 2003/44**

(73) Patentinhaber: **SIEMENS AKTIENGESELLSCHAFT**
**80333 München (DE)**

(72) Erfinder:
• **JELONNEK, Björn**
**89079 Ulm (DE)**

• **SPLETT, Armin**
**89081 Ulm (DE)**

(56) Entgegenhaltungen:
**EP-A- 0 454 406        JP-A- 8 330 968**

• **MARTIN U ET AL: "ON DIGITAL SYSTEMS WITH NEGATIVE GROUP DELAY UBER DIGITALE SYSTEME MIT NEGATIVER GRUPPENLAUFZEIT" FREQUENZ, SCHIELE UND SCHON GMBH. BERLIN, DE, Bd. 47, Nr. 5/6, 1. Mai 1993 (1993-05-01), Seiten 106-113, XP000368752 ISSN: 0016-1136**

**Beschreibung**

Die vorliegende Erfindung betrifft eine Anordnung zum Laufzeitausgleich einer durch eine Nachbildung eines Hochfrequenzsignals auftretenden Laufzeitdifferenz nach dem Oberbegriff des Anspruchs 1.

Hochfrequente Signale, welche mittels beliebiger Übertragungssysteme linearer oder nichtlinearer Art, wie beispielsweise Verstärkerketten übertragen werden, können durch Signalverarbeitungseinrichtungen nachgebildet werden. Ein Beispiel eines Übertragungssystems zeigt die von der Anmelderin mit gleichem Anmeldetag eingereichte Patentanmeldung, betreffend einen Sigma-Delta-Modulator zur Digitalisierung von analogen Hochfrequenzsignalen. Im Idealfall erfolgt die Signalnachbildung des Ausgangssignals des Übertragungssystems dabei ohne Zeitverzögerung gegenüber dem ursprünglichen Signal, so dass die exakt nachgebildeten Signalanteile des nachgebildeten Signals das ursprüngliche Signal in einem Differenzsignal vollständig auslöschen.

Praktische Realisierungen der Signalnachbildung verursachen jedoch in der Regel eine Laufzeitdifferenz des nachgebildeten gegenüber dem ursprünglichen Signal. Wie nachstehend verdeutlicht werden kann, führt die Zeitverzögerung des nachgebildeten Signals zu einer Auslöschung der Signalanteile nur in einem gewissen Frequenzbereich. Hierbei bezeichnet $x(t)$ das ursprüngliche Ausgangssignal des Übertragungssystems und $\hat{x}(t)$ das nachgebildete Signal; $\tau$ steht fór die Laufzeitdifferenz des nachgebildeten Signals.

Es gilt die Beziehung

$$x(t)-\overset{\wedge}{x}(t) \approx x(t) - x(t-\tau) \Leftrightarrow X(j\omega)-e^{-j\omega\tau}\,X(j\omega) = X(j\omega)\cdot(1-e^{-j\omega\tau})$$

Um eine breitbandige Signalauslöschung zu erzielen, ist der Einsatz von Laufzeitgliedern üblich, die das Signal $x(t)$ um die Zeitdauer der Laufzeitdifferenz $\tau$ der Signalnachbildung $\hat{x}(t)$ verzögern.

$$x(t-\tau)-\overset{\wedge}{x}(t) \approx (t-\tau)-x(t-\tau)=0$$

Die hierzu eingesetzten hochlinearen Laufzeitglieder sind aufgrund der hohen spektralen Reinheit des Signals $x(t)$ techriisch aufwendig und verursachen hohe Herstellungskosten.

Aufgabe der Erfindung ist es daher, eine Anordnung zum Laufzeitausgleich einer durch eine Nachbildung eines Hochfrequenzsignals auftretenden Laufzeitdifferenz zu schaffen, die eine breitbandige Signalnachbildung ermöglicht und dabei technisch einfach realisierbar ist.

Die Aufgabe wird gelöst durch eine Anordnung zum Laufzeitausgleich einer durch eine Nachbildung eines Hochfrequenzsignals auftretenden Laufzeitdifferenz mit einem nachzubildenden Signal $x(t)$, mit einer Signalverarbeitungseinrichtung, welche das Signal $x(t)$ durch ein Signal $\hat{x}(t)$ nachbildet, und mit einer Einrichtung zur Ermittlung eines Differenzsignals der Signale $x(t)$ und $\hat{x}(t)$, welche dadurch gekennzeichnet ist, dass das nachgebildete Signal $\hat{x}(t)$ über ein Filter mit für bestimmte Frequenzbereiche negativer Gruppenlaufzeit geführt wird. Dabei werden die Parameter des Filters derart gewählt, dass die Gesamtübertragungsfunktion des Differenzsignals in dem gewünschten Frequenzbereich Nullstellen aufweist bzw. stark gedämpft wird. In diesem Frequenzbereich wird somit die aus der Signalnachbildung resultierende Laufzeitdifferenz weitestgehend kompensiert.

Nach einer Ausführungsform der Erfindung bildet das Signal x(t) das Ausgangssignal eines Übertragungssystems und ein Signal u(t) bildet das Eingangssignal des Übertragungssystems. Das Übertragungssystem kann hierbei z.B. aus einem Verstärker oder auch einer Verstärkerkette bestehen. Es kann aber ein beliebiges lineares oder nichtlineares Übertragungssystem eingesetzt werden.

Gemäß einer weiteren Ausführungsform der Erfindung weist die Anordnung eine Regelungseinrichtung auf, durch die das nachgebildete Signal $\hat{x}(t)$ veränderbar ist, derart, dass das Differenzsignal minimal wird.

Bevorzugt wird das Differenzsignal zur Regelung der Signalnachbildung zu der Signalverarbeitungseinrichtung geführt.

Nach einer Ausführungsform der Erfindung ist eine Signalauswertungseinheit vorgesehen, welche das Differenzsignal auswertet und das ausgewertete Signal zu der Signalverarbeitungseinrichtung führt.

Nach einer bevorzugten Ausführungsform der Erfindung wird das analoge Eingangssignal zur Steuerung der Signalnachbildung zu der Signalverarbeitungseinrichtung geführt.

Bevorzugt weist das Filter Laufzeitglieder auf, welche das digitale Signal verzögern.

Vorzugsweise wird zur Lösung der Aufgabe ein lineares Filter eingesetzt. Es kann beispielsweise ein FIR-, ein IIR oder auch jedes andere lineare Filter verwendet werden.

Ausführungsbeispiele der Erfindung werden nachstehend anhand der beiliegenden Zeichnungen erläutert.

Dabei zeigen:

Fig. 1 eine Darstellung einer Anordnung zur Signalnachbildung gemäß dem Stand der Technik,

Fig. 2 eine Darstellung einer erfindungsgemäßen Anordnung zur Signalnachbildung,

Fig. 3 eine Darstellung einer weiteren Ausführungsform einer erfindungsgemäßen Anordnung zur Signalnachbildung,

Fig. 4 eine Darstellung eines Anwendungsbeispiels der erfindungsgemäßen Anordnung zur Signalnachbildung, und

Fig. 5 eine Darstellung einer zweiten Ausführungsform einer erfindungsgemäßen Anordnung zur Signalnachbildung.

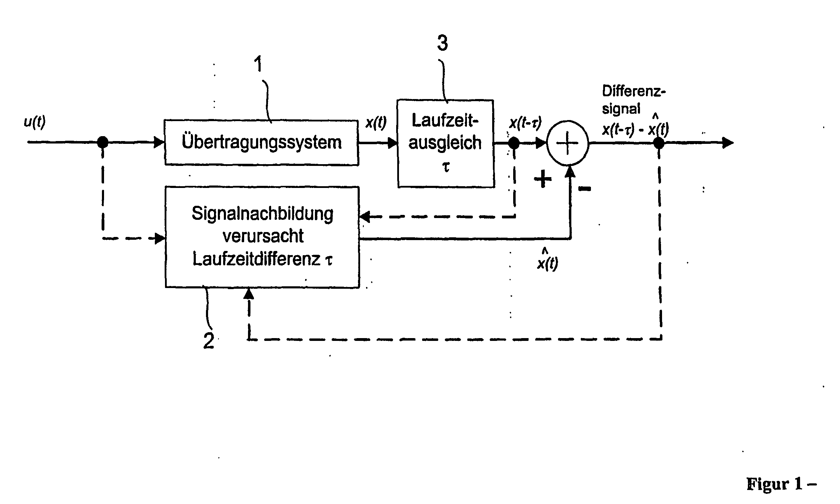

Die in Fig. 1 gezeigte Anordnung zur Signalnachbildung, wie sie aus dem Stand bekannt ist, weist ein Eingangssignal u(t) auf, welches durch ein beliebiges lineares oder nichtlineares Übertragungssystem 1 übertragen wird. Am Ausgang des Übertragungssystems 1 liegt das Signal x(t) an. Das Signal x(t) wird in der Signalverarbeitungseinrichtung 2 nachgebildet, wobei Laufzeitdifferenzen, d.h. Verzögerungen gegenüber dem Signal x(t) auftreten. Am Ausgang der Signalverarbeitungseinrichtung 2 liegt das Signal $\hat{x}(t)$ an. Zum Ausgleich der Laufzeitdifferenzen ist für das Signal x(t) ein Laufzeitglied 3 vorgesehen, welches das Signal x(t) um eine Zeit τ verzögert. Dabei wird τ vorzugsweise derart gewählt, dass es der durch die Signalverarbeitungseinrichtung 2 verursachten Laufzeitdifferenz entspricht. Eine ideale Signalnachbildung sowie eine Verzögerung τ vorausgesetzt, welche exakt der durch die Signalnachbildung hervorgerufenen Signalverzögerung entspricht, gilt für das aus $\hat{x}(t)$ und dem verzögerten Signal x(t-τ) gebildete Differenzsignal x(t-τ)-$\hat{x}(t)$ für alle Frequenzen

$$x(t-\tau)- \overset{\wedge}{x}(t) = 0$$

Zur Verbesserung der Signalnachbildung kann ein Regelkreis gebildet werden, der das Differenzsignal, welches im Normalfall ungleich 0 ist, an die Signalverarbeitungseinrichtung 2 sendet. Es kann auch das verzögerte Signal x(t-τ) als Regelgröße verwendet werden.

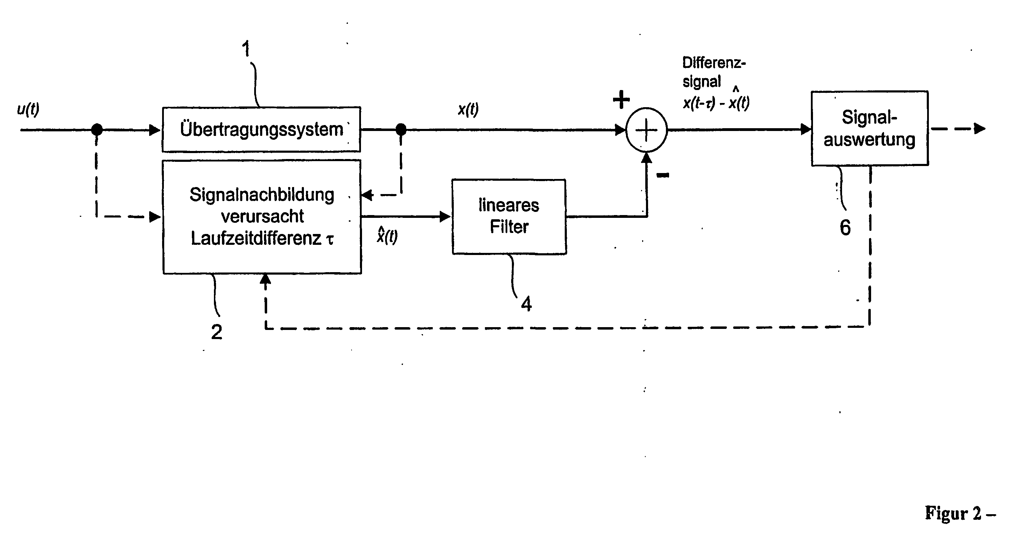

Gemäß der vorliegenden Erfindung wird auf den Einsatz eines Laufzeitglieds zur Kompensation der Laufzeitdifferenz verzichtet. Eine Darstellung der Erfindung zeigt Fig. 2.

Das nachgebildete Signal $\hat{x}(t)$ wird als Eingangssignal auf ein lineares Filter 4 gegeben. Es kann dabei ein FIR-, IIR- oder ein beliebiges anderes lineares Filter eingesetzt werden. Die Koeffizienten des linearen Filters werden derart gewählt, dass für bestimmte Frequenzbereiche die durch die Signalverarbeitungseinrichtung 2 verursachte Laufzeitdifferenz durch das lineare Filter kompensiert wird. Das eingesetzte Filter weist in den bestimmten Frequenzbereichen eine negative Gruppenlaufzeit auf, ist aber wegen positiver Gruppenlaufzeiten in anderen Frequenzbereichen, d.h. Verzögerungen des Signals, dennoch kausal und daher realisierbar. Auf diese Weise wird im gewünschten Frequenzbereich eine Signalnachbildung erreicht, welche im Vergleich zu bisherigen Lösungen breitbandiger und aufgrund der eingesetzten digitalen Filter einfach zu realisieren ist. Das an dem Summierer 5 gebildete Differenzsignal kann als Regelgröße für die Signalverarbeitungseinrichtung 2 eingesetzt werden. Es ist jedoch auch denkbar, eine Auswertung des Differenzsignals als Regelgröße heranzuziehen. Hierzu wird eine Signalauswertungseinheit 6 eingesetzt, welche beispielsweise das Differenzsignal in eine Taylorreihe umwandelt. Es können erfindungsgemäß auch andere Arten der Signalzerlegung eingesetzt werden.

Ein weiteres Beispiel für eine Signalzerlegung ist die Spektralanalyse (Fourieranalyse) des Differenzsignals. Ziel ist es, die Leistung des Differenzsignals innerhalb eines Teilbandes zu minimieren. Hierfür ist es ausreichend, diejenigen Ergebnisse der Spektralanalyse des Differenzsignals an die Signalverarbeitungseinrichtung 2 zu senden, die den Frequenzgang innerhalb des betrachteten Teilbandes beschreiben.

Als weitere alternative parametrische Regelgröße kann die Leistung des Fehlersignals innerhalb des betrachteten Frequenzbandes verwendet werden.

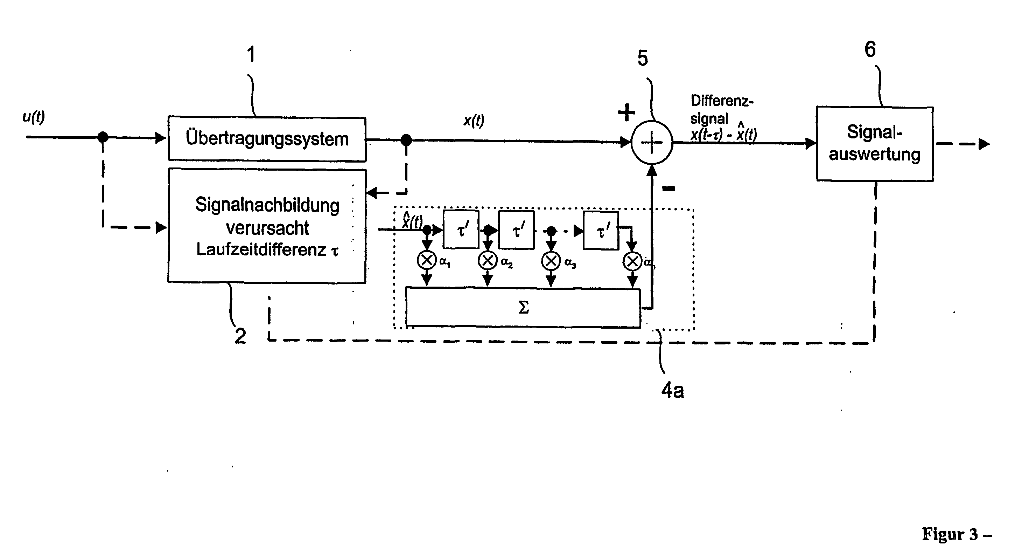

Im folgenden wird eine Ausführungsform der Erfindung an einem Beispiel nach Fig. 3 beschrieben. In diesem Beispiel wird ein FIR-Filter 4a zur Erzielung der negativen Gruppenlaufzeit für bestimmte Frequenzbereiche verwendet. Es soll ein Laufzeitausgleich im Tiefpaßbereich vorgenommen werden. Für die Verzögerungsglieder τ' des Filters soll gelten

$$\tau' = \tau,$$

d.h. die Verzögerungsglieder t' des Filters entsprechen jeweils der Laufzeitdifferenz t der Signalverarbeitungseinrichtung. Den Ausgangspunkt bildet ein linearer Filterentwurf mit guter Sperrdämpfung bei der Frequenz $\underline{\omega}$ = 0:

$$H_{Entwurf} = 1 - \sum_{l=1}^{q-1} \alpha_l z^{-l}$$

mit q = 1, 2, 3, ... und 1 = 1, 2, 3, ....

In diesem Beispiel wird

$$H_{Entwurf} = (1 - z^{-1})^v$$

mit $v=2$ und $z=e^{j\omega\tau}$

gewählt. Es ergibt sich somit für das Differenzsignal $y(t)$ am Ausgang des Summierers 5

$$y(t) = x(t) + \sum_{l=1}^{q-1} \alpha_l \hat{x}(t - (l-1)\tau) = x(t) - 2\hat{x}(t) + \hat{x}(t-\tau) \approx x(t) - 2x(t-\tau) + x(t-2\tau)$$

Aus der Linearität der Fouriertransformation folgt

$$Y(e^{j\omega}) = (1 - e^{-j\omega\tau})^2 X(e^{j\omega}) = (1 - 2e^{-j\omega\tau} + e^{-j\omega 2\tau}) X(e^{j\omega})$$

$$= X(e^{j\omega}) - 2e^{-j\omega\tau} X(e^{j\omega}) + e^{-j\omega 2\tau} X(e^{j\omega})$$

korrespondiert mit

$$y(t) = x(t) - 2x(t-\tau) + x(t+2\tau)$$

Die Definition der Gruppenlaufzeit nach K. D. Kammeyer, Nachrichtenübertragung, Teubner Stuttgart 1996, lautet wie folgt

$$\tau_g(\omega) = -\frac{d\varphi(\omega)}{d\omega}$$

Frequenzgang des betrachteten Teilsystems

$$H_{teil} = 2 - e^{-j\omega\tau}$$

Bei Frequenzen $\omega\tau \approx 2\pi$ ist $e^{-j\omega 2\pi} \approx 1 - j(\omega\tau - 2\pi)$ (Taylorreihenentwicklung). Damit gilt annähernd

$$H_{teil} = 2 - (1 - j(\omega\tau - 2\pi)) = 1 + j(\omega\tau - 2\pi))$$

Die Phase beträgt approximativ $\omega\tau - 2\pi$, die Ableitung nach $\omega$ ergibt negative Werte: $-\tau$ ist diejenige Gruppenlaufzeit, die kompensiert werden soll.

Für das dargestellte Filter werden daher die Koeffizienten $\alpha_1 ... \alpha_n$ wie folgt gewählt: $\alpha_1$ = 2, $\alpha_2$ = -1 und $\alpha_3 ... \alpha_n$ = 0

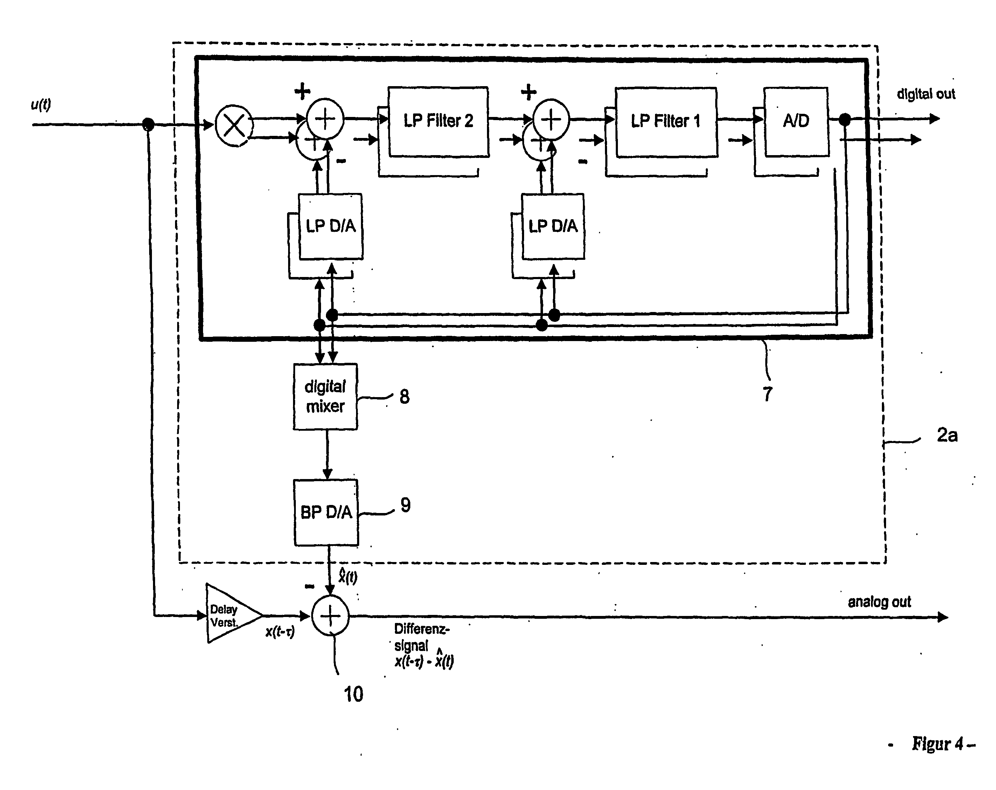

Ein konkretes Anwendungsbeispiel der Erfindung zeigt Fig. 4. Es ist eine Kaskadenstufe eines Analog-Digital-Wandlersystems mit einem Tiefpaß-Sigma-Delta-Modulator 7 dargestellt, welches Gegenstand einer weiteren Patentanmeldung der Anmelderin ist. Die digitale Signalnachbildung des analogen Eingangssignals u(t) wird hier durch den Tiefpaß-Sigma-Delta-Modulator 7 erzielt. Die beiden Ausgangssignale einer Signalverarbeitungseinrichtung 2a, welche durch die Multiplikation des Eingangssignals u(t) mit ein sin- bzw. einem cos-Signal entstehen und als Inphase- bzw. Quadraturkomponente bezeichnet werden, werden in dem digitalen Mischer 8 wieder zu einem Signal zusammengesetzt und anschließend in einem Bandpaß-Digital-Analog-Wandler 9 analogisiert. Das Ausgangssignal des Bandpaß-Digital-Analog-Wandlers 9 wird mit negativem Vorzeichen auf einen Summierer 10 geführt. Das Eingangssignal u(t) wird zur Amplitudenanpassung in einem Verstärker 11 verstärkt und gelangt zu dem Summierer 10. Gemäß dem Stand der Technik wird das Signal u(t) zusätzlich verzögert, um die durch die Signalverarbeitungseinrichtung 2a eingebrachte Verzögerung des Eingangssignals auszugleichen.

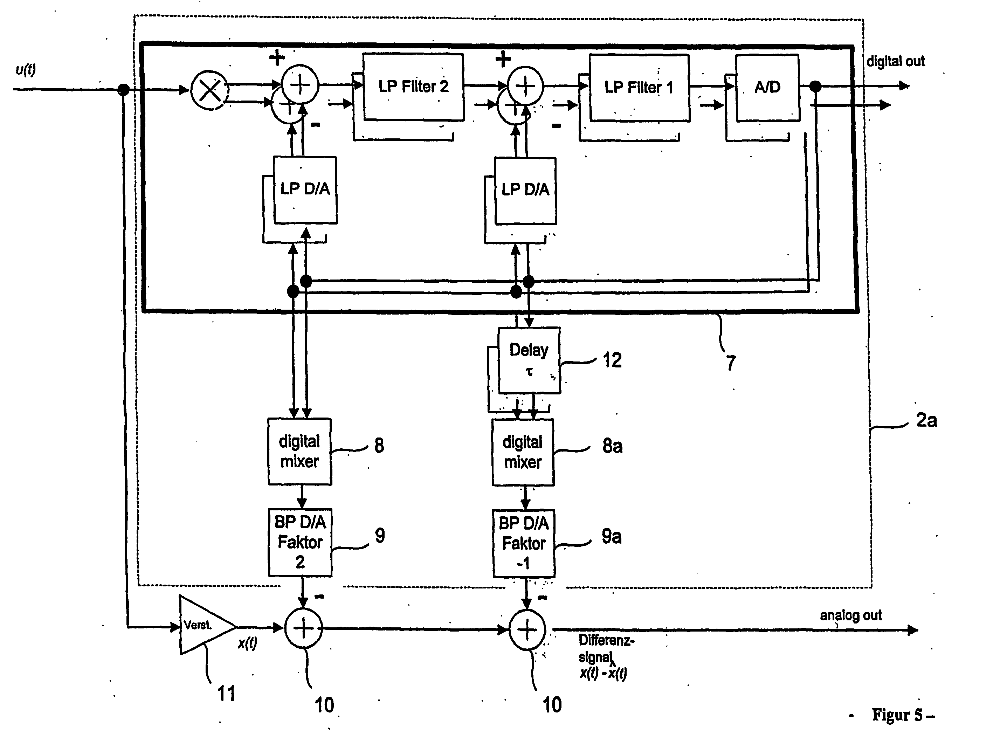

Eine erfindungsgemäße Realisierung eines Laufzeitausgleichs ausgehend von dem in Fig. 4 dargestellten Anwendungsbeispiel zeigt Fig. 5. Es wird hier ein digitales Filter mit den Koeffizienten $\alpha_1$ = 2 und $\alpha_2$ = -1 eingesetzt. Wie obenstehend beschrieben, weist dieses Filter eine hohe Sperrdämpfung bei $\omega$ = 0 auf. Die Inphase- und die Quadraturkomponente des Tiefpaß-Sigma-Delta-Modulators 7 werden zum einen über einen digitalen Mischer 8 geführt, mit dem Koeffizienten $\alpha_1$ = 2 multipliziert und in einem Bandpaß-Digital-Analog-Wandler 9 in ein analoges Signal umgewandelt.

Anschließend wird das Signal mit negativem Vorzeichen einem Summierer 10 zugeführt. Ferner werden die Inphase- und die Quadraturkomponente des Tiefpaß-Sigma-Delta-Modulators 7 in einem Verzögerungsglied 12 um $\tau$ verzögert, in einem Mischer 8a zusammengeführt und mit dem Koeffizienten $\alpha_2$ = -1 multipliziert. Nach einer Umwandlung in ein analoges Signal in einem Bandpaß-Digital-Analog-Wandler 9a wird dieses dem Summierer 10 mit negativem Vorzeichen zugeführt. Das Eingangssignal u(t) erfährt eine Amplitudenanpassung mittels eines Verstärkers 11, wird jedoch nicht wie in Fig. 4 verzögert. Durch das den digitalen Mischern nachgeschaltete Filter weisen Frequenzen im Bereich $\omega$ = $2\pi$ eine negative Gruppenlaufzeit auf, so dass die durch die Signalverarbeitungseinrichtung 2a verursachte Verzögerung für diesen Frequenzbereich kompensiert wird. In anderen Frequenzbereichen ist die Gruppenlaufzeit zwar positiv, jedoch ist das Ausgangssignal ohnehin bandbegrenzt, so dass keine zusätzliche Einschränkung durch das digitale Filter entsteht.

**Patentansprüche**

1. Anordnung zum Laufzeitausgleich einer durch eine Nachbildung eines Hochfrequenzsignals auftretenden Laufzeitdifferenz mit einem nachzubildenden Signal x(t), mit einer Signalverarbeitungseinrichtung, welche das Signal x(t) durch ein Signal $\hat{x}(t)$ nachbildet, und mit einer Einrichtung zur Ermittlung eines Differenzsignals der Signale x(t) und $\hat{x}(t)$, **dadurch gekennzeichnet, dass** das nachgebildete Signal $\hat{x}(t)$ über ein Filter mit für bestimmte Frequenzbereiche negativer Gruppenlaufzeit geführt wird.

2. Anordnung nach Anspruch 1, **dadurch gekennzeichnet, dass** das Signal x(t) das Ausgangssignal eines Übertragungssystems bildet und ein Signal u(t) das Eingangssignal des Übertragungssystems bildet.

3. Anordnung nach Anspruch 1 oder 2, **dadurch gekennzeichnet, dass** sie eine Regelungseinrichtung aufweist, durch die das nachgebildete Signal $\hat{x}(t)$ veränderbar ist, derart, dass das Differenzsignal minimal wird.

4. Anordnung nach Anspruch 3, **dadurch gekennzeichnet, dass** das Differenzsignal zur Regelung der Signalnachbildung zu der Signalverarbeitungseinrichtung geführt wird.

5. Anordnung nach einem der vorhergehenden Ansprüche, **dadurch gekennzeichnet, dass** eine Signalauswertungseinheit vorgesehen ist, welche das Differenzsignal auswertet und das ausgewertete Signal zu der Signalverarbeitungseinrichtung führt.

6. Anordnung nach einem der vorhergehenden Ansprüche, **dadurch gekennzeichnet, dass** das analoge Eingangssignal zur Steuerung der Signalnachbildung zu der Signalverarbeitungseinrichtung geführt wird.

7. Anordnung nach einem der vorhergehenden Ansprüche, **dadurch gekennzeichnet, dass** das Filter Laufzeitglieder aufweist.

8. Anordnung nach einem der vorhergehenden Ansprüche, **dadurch gekennzeichnet, dass** das Filter linear ist.

9. Anordnung nach einem der Ansprüche 1 bis 8, **dadurch gekennzeichnet, dass** das Filter ein FIR-Filter ist.

10. Anordnung nach einem der Ansprüche 1 bis 8, **dadurch gekennzeichnet, dass** das Filter ein IIR-Filter ist.

**Claims**

1. Arrangement for runtime compensation of a runtime difference arising through emulation of a high frequency signal with a signal to be emulated x(t), with a signal processing device, which emulates the signal x(t) with a signal $\hat{x}(t)$, and with a device for determining a difference signal between the signals x(t) and $\hat{x}(t)$, **characterised in that** the emulated signal $\hat{x}(t)$ is routed via a filter with negative group runtime for certain frequency ranges.

2. Arrangement according to claim 1, **characterised in that** the signal x(t) forms the output signal of a transmission system and a signal u(t) forms the input signal of the transmission system.

3. Arrangement according to claim 1 or 2, **characterised in that** it has a regulation device, by means of which the emulated signal $\hat{x}(t)$, can be modified so that the difference signal becomes minimal.

4. Arrangement according to claim 3, **characterised in that** the difference signal for regulating signal emulation is routed to the signal processing device.

5. Arrangement according to one of the preceding claims, **characterised in that** a signal evaluation unit is provided, which evaluates the difference signal and routes the evaluated signal to the signal processing device.

6. Arrangement according to one of the preceding claims, **characterised in that** the analogue input signal for controlling signal emulation is routed to the signal processing device.

7. Arrangement according to one of the preceding claims, **characterised in that** the filter has runtime elements.

8. Arrangement according to one of the preceding claims, **characterised in that** the filter is linear.

9. Arrangement according to one of claims 1 to 8, **characterised in that** the filter is an FIR filter.

10. Arrangement according to one of claims 1 to 8, **characterised in that** the filter is an IIR filter.


**Revendications**

1. Dispositif pour la compensation du temps de propagation d'une différence de temps de propagation apparaissant du fait d'une simulation d'un signal de haute fréquence avec un signal x(t) à simuler, avec un dispositif de traitement de signal, qui simule le signal x(t) par un signal $\hat{x}(t)$, et avec un dispositif pour le calcul d'un signal différentiel des signaux x(t) et $\hat{x}(t)$, **caractérisé en ce que** le signal $\hat{x}(t)$ simulé est guidé au moyen d'un filtre avec un temps de propagation de groupe négatif pour certaines plages de fréquence.

2. Dispositif selon la revendication 1, **caractérisé en ce que** le signal x(t) forme le signal de sortie d'un signal de transmission et un signal u(t) forme le signal d'entrée du système de transmission.

3. Dispositif selon la revendication 1 ou 2, **caractérisé en ce qu'**il présente un système de réglage, par lequel le signal $\hat{x}(t)$ simulé peut être modifié de telle sorte que le signal différentiel devient minimal.

4. Dispositif selon la revendication 3, **caractérisé en ce que** le signal différentiel pour le réglage de la simulation du signal est guidé vers le dispositif de traitement de signal.

5. Dispositif selon l'une quelconque des revendications précédentes, **caractérisé en ce qu'**une unité d'analyse de signal est prévue, laquelle analyse le signal différentiel et guide le signal analysé vers le dispositif de traitement de signal.

6. Dispositif selon l'une quelconque des revendications précédentes, **caractérisé en ce que** le signal d'entrée analogique pour la commande de la simulation du signal est guidé vers le dispositif de traitement de signal.

7. Dispositif selon l'une quelconque des revendications précédentes, **caractérisé en ce que** le signal présente des éléments de retard.

**8.** Dispositif selon l'une quelconque des revendications précédentes, **caractérisé en ce que** le filtre est linéaire.

**9.** Dispositif selon l'une quelconque des revendications 1 à 8, **caractérisé en ce que** le filtre est un filtre FIR.

**10.** Dispositif selon l'une quelconque des revendications 1 à 8, **caractérisé en ce que** le filtre est un filtre IIR.

EP 1 356 593 B1

8

$u(t)$

1

**Übertragungssystem**

$x(t)$

3

**Laufzeit-ausgleich** $\tau$

$x(t-\tau)$

Differenz-signal
$\hat{x}(t-\tau) - \hat{x}(t)$

$+$ $-$

**Signalnachbildung verursacht Laufzeitdifferenz $\tau$**

$\hat{x}(t)$

2

**Figur 1 –**

EP 1 356 593 B1

Übertragungssystem — 1

Signalnachbildung verursacht Laufzeitdifferenz τ — 2

lineares Filter — 4

Signal-auswertung — 6

$u(t)$

$x(t)$

$\hat{x}(t)$

Differenz-signal $x(t-\tau) - \hat{x}(t)$

**Figur 2 –**

9

Figur 3 –

– Figur 4 –

Figur 5 –